# EUROPÄISCHE PATENTANMELDUNG

(11) **EP 4 718 485 A1**
(43) Veröffentlichungstag der Anmeldung: **01.04.2026**
(21) Anmeldenummer: 25200521.0
(22) Anmeldetag: 05.09.2025
(51) Int. Cl.: H01F 38/32, H01F 38/36, H01F 38/38, H01F 38/40, H01H 71/12, G01R 19/25

(54) **SUMMENSTROMWANDLER-BAUGRUPPE UND GERÄT ZUR FEHLERSTROMERFASSUNG**

(30) Priorität: 25.09.2024 DE 102024209258
(71) Anmelder: Siemens Aktiengesellschaft, 80333 München (DE)
(72) Erfinder: Schaich, Sebastian, 93055 Regensburg (DE); Schindler, Florian, 93055 Regensburg (DE)
(74) Vertreter: Siemens Patent Attorneys

(57) **Zusammenfassung**

Die erfindungsgemäße Summenstromwandler-Baugruppe (100, 100', 100", 100‴) für ein Fehlerstromerfassungsgerät (1, 1', 1", 1‴) weist neben einem ersten Messwandler (101) zur Erfassung eines Fehlerstroms eine erste Strommesseinrichtung (111, 112, 114) zur Erfassung eines in einem ersten Phasenleiter (P₁) des Fehlerstromerfassungsgerätes (1, 1', 1", 1‴) fließenden Laststroms auf. Weiterhin weist die Summenstromwandler-Baugruppe (100, 100', 100", 100‴) eine Leiterplatte (121), auf der eine elektrische Schaltung zur Messung der Spannung in dem ersten Phasenleiter (P₁) angeordnet ist, auf. Dabei sind der erste Messwandler (101) sowie die ersten Strommesseinrichtung (111, 112, 114) an der Leiterplatte (121) befestigt sowie elektrisch leitend mit dieser verbunden. Mit Hilfe der kompakten Summenstromwandler-Baugruppe (100, 100', 100", 100‴) ist es möglich, eine Funktionalität zur Fehlerstromanzeige und -überwachung (sogenanntes "Residual Current Monitoring", kurz: RCM) oder zur Energiemessung (sogenanntes "Energy Meetering", kurz: EM) in einen bestehenden Fehlerstromschutzschalter (1, 1', 1", 1‴) zu integrieren. Ein eigenständiges, zusätzlich zu installierendes Schaltgerät zur Realisierung dieser Funktion ist somit nicht mehr erforderlich. Hieraus ergibt sich zum einen ein Kostenvorteil für den Kunden, zum anderen wird kein zusätzlicher Platz im Elektroinstallationsverteiler benötigt. Auch die Nachrüstung bestehende Anlagen wird dadurch deutlich vereinfacht.

## Beschreibung

Die Erfindung betrifft eine Summenstromwandler-Baugruppe für ein Fehlerstromerfassungsgerät sowie ein Gerät zur Fehlerstromerfassung mit einer solchen Summenstromwandler-Baugruppe.

Elektromechanische Schutzschaltgeräte - beispielsweise Leistungsschalter, Leitungsschutzschalter, Fehlerstromschutzschalter sowie Lichtbogen- bzw. Brandschutzschalter - dienen der Überwachung sowie der Absicherung eines elektrischen Stromkreises und werden insbesondere als Schalt- und Sicherheitselemente in elektrischen Energieversorgungs- und Verteilnetzen eingesetzt. Zur Überwachung und Absicherung des elektrischen Stromkreises wird das Schutzschaltgerät über zwei oder mehrere Anschlussklemmen mit einer elektrischen Leitung des zu überwachenden Stromkreises elektrisch leitend verbunden, um bei Bedarf den elektrischen Strom in der jeweiligen überwachten Leitung zu unterbrechen. Das Schutzschaltgerät weist hierzu zumindest einen Schaltkontakt auf, der bei Auftreten eines vordefinierten Zustandes - beispielsweise bei Erfassen eines Kurzschlusses oder eines Fehlerstromes - geöffnet werden kann, um den überwachten Stromkreis vom elektrischen Leitungsnetz zu trennen. Derartige Schutzschaltgeräte sind auf dem Gebiet der Niederspannungstechnik auch als Reiheneinbaugeräte bekannt.

Leistungsschalter sind speziell für hohe Ströme ausgelegt. Ein Leitungsschutzschalter (sogenannter LS-Schalter), welcher auch als "Miniature Circuit Breaker" (MCB) bezeichnet wird, stellt in der Elektroinstallation eine sogenannte Überstromschutzeinrichtung dar und wird insbesondere im Bereich der Niederspannungsnetze eingesetzt. Leistungsschalter und Leitungsschutzschalter garantieren ein sicheres Abschalten bei Kurzschluss und schützen Verbraucher und Anlagen vor Überlast. Auf diese Weise werden beispielsweise elektrische Leitungen vor Beschädigung durch eine zu starke Erwärmung in Folge eines zu hohen elektrischen Stromes geschützt.

Zur Unterbrechung eines einzigen Phasenleiters wird in der Regel ein einpoliger Leitungsschutzschalter verwendet, welche üblicherweise eine Breite von einer Teilungseinheit (entspricht ca. 18mm) aufweist. Für dreiphasige Anschlüsse werden (alternativ zu drei einpoligen Schaltgeräten) dreipolige Leitungsschutzschalter eingesetzt, welche dementsprechend eine Breite von drei Teilungseinheiten (entspricht ca. 54mm) aufweisen. Jedem der drei Phasenleiter ist dabei ein Pol, d.h. eine Schaltstelle zugeordnet. Soll zusätzlich zu den drei Phasenleitern auch noch der Neutralleiter unterbrochen werden, spricht man von vierpoligen Geräten, welche vier Schaltstellen aufweisen: drei Schaltstellen für die drei Phasenleiter sowie eine weitere Schaltstelle für den gemeinsamen Neutralleiter.

Ein Gerät zur Fehlerstromerfassung ist beispielsweise ein Fehlerstromschutzschalter. Dabei handelt es sich um eine Schutzeinrichtung zur Gewährleistung eines Schutzes gegen einen gefährlichen Fehlerstrom in einer elektrischen Anlage. Ein derartiger Fehlerstrom, welcher auch als Differenzstrom bezeichnet wird, tritt auf, wenn ein spannungsführendes Leitungsteil einen elektrischen Kontakt gegen Erde aufweist. Dies ist beispielsweise dann der Fall, wenn eine Person ein spannungsführendes Teil einer elektrischen Anlage berührt: in diesem Fall fließt der Strom als Fehlerstrom durch den Körper der betreffenden Person gegen die Erdung ab. Zum Schutz gegen derartige Körperströme muss der Fehlerstromschutzschalter bei Auftreten eines derartigen Fehlerstroms die elektrische Anlage schnell und sicher allpolig vom Leitungsnetz trennen. Im Allgemeinen Sprachgebrauch werden anstelle des Begriffs "Fehlerstromschutzschalter" auch die Begriffe FI-Schutzschalter (kurz: FI-Schalter), Differenzstromschutzschalter (kurz: DI-Schalter) oder RCD (für "Residual Current Protective Device") gleichwertig verwendet.

Bei der elektrischen Ausrüstung von Gebäuden wird zumeist eine Vielzahl von Schutzschaltgeräten benötigt, welche in einem sogenannten Elektroinstallationsverteiler, auch als Verteilerkasten oder kurz als Verteiler bezeichnet, zusammengefasst und nebeneinander angeordnet sind. Im Inneren des Elektroinstallationsverteilers sind zumeist Halterungen zur Strukturierung des Innenaufbaus des Verteilers sowie Stromführungssysteme zum Anschluss der elektrischen und/oder elektronischen Komponenten vorgesehen. Mit Hilfe einer sogenannten Trag- oder Hutschiene können die Elektroinstallationsgeräte auf einfache Art und Weise durch Aufstecken oder Aufschieben befestigt werden: Durch Hintergreifen eines oder mehrerer am Elektroinstallationsgerät ausgebildeten Rastelemente wird dabei eine formschlüssige Fixierung des Elektroinstallationsgeräts im Verteilerkasten erreicht. Auf diese Weise wird eine Möglichkeit zur standardisierten Befestigung der Elektroinstallationsgeräte geschaffen, wodurch die Montagekosten bei der elektrischen Ausrüstung des Elektroinstallationsverteilers deutlich reduziert werden.

Neben den bereits angesprochenen Schutzschaltgeräten Leistungsschalter, Leitungsschutzschalter und Fehlerstromschutzschalter gibt es auch kombinierte Gerätebauformen, bei denen die Funktionalität eines Fehlerstrom-Schutzschalters um die Funktionalität eines Leitungsschutzschalters ergänzt wird: derartige kombinierte Schutzschaltgeräte werden im Deutschen als FI/LS oder im englischsprachigen Raum als RCBO (für Residual current operated Circuit-Breaker with Overcurrent protection) bezeichnet. Diese Kombigeräte haben im Vergleich zu getrennten Fehlerstrom- und Leitungsschutzschaltern den Vorteil, dass jeder Stromkreis seinen eigenen Fehlerstromschutzschalter aufweist: Normalerweise wird ein einziger Fehlerstromschutzschalter für mehrere Stromkreise verwendet. Kommt es zu einem Fehlerstrom, werden somit in Folge alle abgesicherten Stromkreise abgeschaltet. Durch den Einsatz eines RCBOs wird hingegen nur der jeweils betroffene Stromkreis abgeschaltet.

Weiterhin existieren Geräte zur Fehlerstromerfassung, die über keine Schutzfunktion verfügen, d.h. die mit Hilfe des Gerätes überwachte elektrische Leitung wird im Falle des Auftretens eines Fehlerstroms nicht unterbrochen. Derartige Geräte sind unter dem Begriff RCM (englisch für "Residual Current Monitoring") bekannt.

Tendenziell werden immer mehr Funktionalitäten in die Geräte integriert, d.h. es werden kombinierte Schutzschaltgeräte entwickelt, welche den Funktionsumfang mehrerer Einzelgeräte abdecken: neben den vorstehend bereits beschriebenen FI/LS-Schutzschaltgeräten, welche den Funktionsumfang eines herkömmlichen Fehlerstromschutzschalters (FI) mit dem eines Leitungsschutzschalters (LS) kombinieren, existieren weitere Bauformen, bei denen beispielsweise die Funktionalität eines Brandschutzschalters, eine zusätzliche Kommunikationsfunktion sowie die Funktionalität einer Fehlerstromüberwachung (sogenanntes "Residual Current Monitoring", kurz: RCM) oder der Leistungs- und Energiemessung (sogenanntes "Energy Meetering, kurz: EM) in bestehende Geräte wie MCB, RCD oder RCBO/FILS integriert werden. Durch die Integration dieser Funktionalitäten in bestehende Geräte können sogenannte Kombigeräte wie beispielsweise ein MCB-RCM/EM oder ein RCBO-RCM/EM gebildet werden, welche die Funktionalität eines Leitungsschutzschalters (MCB) oder eines RCBOs um die Funktion einer Fehlerstromüberwachung (RCM) und/oder der Leistungs- und Energiemessung (EM) erweitern bzw. ergänzen.

Um die dabei entstehende Vielzahl an Reiheneinbaugeräten für die verschiedensten Anwendungsfälle - und damit die Herstellkosten der einzelnen Geräte - zu begrenzen bzw. reduzieren, wird versucht, die Geräte modular nach dem Baukastenprinzip aufzubauen: Bei einem modularisierten Aufbau werden Systeme aus Bauteilen entlang definierter Schnittstellen zusammengesetzt. Dabei werden die aus dem Baukasten zu bildenden Schutzschaltgeräte in verschiedene Baugruppen bzw. Komponenten, die als Module bezeichnet werden, aufgeteilt, und die Schnittstellen der einzelnen Module zueinander exakt definiert. Bei geeigneter Form und Funktion können dann aus den verschiedenen Modulen unterschiedliche Schutzschaltgeräte gebildet werden, wobei die ausgewählten Module über die vordefinierten Schnittstellen miteinander interagieren.

Vor diesem Hintergrund ist es die Aufgabe der vorliegenden Erfindung, eine Summenstromwandler-Baugruppe für ein Fehlerstromerfassungsgerät bereitzustellen, welche sich durch eine kompakte Bauweise auszeichnet. Ferner ist eine weitere Aufgabe der vorliegenden Erfindung ein Gerät zur Fehlerstromerfassung mit einer derartigen Summenstromwandler-Baugruppe bereitzustellen.

Diese Aufgabe wird erfindungsgemäß durch die Summenstromwandler-Baugruppe sowie das Gerät zur Fehlerstromerfassung gemäß den unabhängigen Ansprüchen gelöst. Vorteilhafte Ausgestaltungen sind Gegenstand der abhängigen Ansprüche.

Die erfindungsgemäße Summenstromwandler-Baugruppe für ein Fehlerstromerfassungsgerät weist neben einem ersten Messwandler zur Erfassung eines Fehlerstroms eine erste Strommesseinrichtung zur Erfassung eines in einem ersten Phasenleiter des Fehlerstromerfassungsgerätes fließenden Laststroms auf. Weiterhin weist die Summenstromwandler-Baugruppe eine Leiterplatte, auf der eine elektrische Schaltung zur Messung der Spannung in dem ersten Phasenleiter angeordnet ist, auf. Dabei sind der erste Messwandler sowie die ersten Strommesseinrichtung an der Leiterplatte befestigt sowie elektrisch leitend mit dieser verbunden.

Unter dem Begriff "Gerät zur Fehlerstromerfassung" werden sowohl Fehlerstromschutzschalter mit eigener Schutzfunktion, welche bei Auftreten eines Fehlerstroms die überwachte elektrische Leitung unterbrechen (beispielsweise FI, FI/LS oder RCBO), als auch Geräte zur Fehlerstromerfassung, die über keine Schutzfunktion verfügen (sogenannte RCM-Geräte), verstanden. Anstelle des Begriffs "Gerät zur Fehlerstromerfassung" wird auch der Begriff "Fehlerstromerfassungsgerät" synonym verwendet.

Mit Hilfe der kompakten Summenstromwandler-Baugruppe ist es möglich, die Funktionalität der Energiemessung (sogenanntes "Energy Meetering, kurz: EM) in einem Fehlerstromerfassungsgerät vordefinierter Baugröße unterzubringen. Die zur Realisierung der Summenstromwandler-Baugruppe benötigte Leiterplatte dient dabei sowohl zur elektronischen Realisierung einiger dieser Funktionalitäten - beispielsweise der Ermittlung des Energieverbrauchs oder der Leistungsanzeige und -kontrolle - als auch zur Fixierung der einzelnen Komponenten wie Messwandler und Strommesseinrichtung. Die EM-Funktionalität zur Energiemessung basiert auf einer Strom- und Spannungsmessung der einzelnen an das Fehlerstromerfassungsgerät angeschlossenen Phasenleiter, wodurch eine Leistungsanzeige und -kontrolle sowie eine Ermittlung des Energieverbrauchs innerhalb eines vordefinierten Zeitraums ermöglicht wird. Damit ist kein zusätzliches Gerät zur Realisierung der EM-Funktionalität mehr erforderlich, wodurch ein Kostenvorteil für den Kunden entsteht und kein zusätzlicher Platz im Elektroinstallationsverteiler benötigt wird. Auch die Nachrüstung für bestehende Anlagen wird dadurch deutlich vereinfacht.

Gemäß einer vorteilhaften Weiterbildung weist die Summenstromwandler-Baugruppe eine zweite Strommesseinrichtung zur Erfassung eines in einem zweiten Phasenleiter des Fehlerstromerfassungsgerätes fließenden Laststroms und/oder eine dritten Strommesseinrichtung zur Erfassung eines in einem dritten Phasenleiter des Fehlerstromerfassungsgerätes fließenden Laststroms auf.

Im Falle eines mehrpoligen Fehlerstromerfassungsgerätes, an den mehrere, d.h. ein zweiter Phasenleiter oder ein zweiter und ein dritter Phasenleiter angeschlossen werden, ist es sinnvoll, für jeden der Phasenleiter eine Strommesseinrichtung vorzusehen, um den elektrischen Strom - und infolgedessen die darüber bereitgestellte elektrische Energie - im jeweiligen Phasenleiter bestimmen zu können. Um auch für ein drei- oder vielpoliges Fehlerstromerfassungsgerät eine kompakte Bauform zu gewährleisten sind auch diese weiteren Strommesseinrichtungen in die Summenstromwandler-Baugruppe integriert, d.h. an der dortigen Leiterplatte aufgenommen und gehaltert sowie mit dieser elektrisch leitend verbunden.

Gemäß einer weiteren vorteilhaften Weiterbildung der Summenstromwandler-Baugruppe sind die erste Strommesseinrichtung und/oder die zweite Strommesseinrichtung und/oder die dritte Strommesseinrichtung als Stromwandler ausgebildet.

Unter dem Begriff "Stromwandler" wird ein induktiver Messwandler oder Messumformer, der eine Eingangsstromgröße (hier: der durch einen der Phasenleiter fließende Primärstrom) in eine Ausgangsstromgröße (hier: den durch einen Sekundärleiter des Stromwandlers fließende Sekundärstrom) umformt. Derartige Stromwandler weisen zumeist einen mit dem Sekundärleiter umwickelten, ringförmigen Magnetkern auf, durch den der betreffende Phasenleiter hindurchgeführt ist. Für den Betrieb eines derartigen Stromwandlers ist keine Versorgungsspannung erforderlich, weshalb deren Einsatz vergleichsweise einfach zu realisieren ist.

Gemäß einer weiteren vorteilhaften Weiterbildung der Summenstromwandler-Baugruppe sind die erste Strommesseinrichtung und/oder die zweite Strommesseinrichtung und/oder die dritte Strommesseinrichtung als Stromsensor, insbesondere als TMR-Sensor oder als Hall-Sensor ausgebildet.

Die Verwendung eines Stromsensors, beispielsweise eines Hall-Sensors oder eines sogenannten TMR-Sensors, stellt eine Alternative zur Realisierung der Strommesseinrichtung dar. Die Verwendung derartiger Sensoren bietet insbesondere den Vorteil, dass der hierfür benötigte Bauraum geringer ist als dies bei der Verwendung von Stromwandlern der Fall wäre.

Gemäß einer weiteren vorteilhaften Weiterbildung der Summenstromwandler-Baugruppe sind die erste Strommesseinrichtung und/oder die zweite Strommesseinrichtung und/oder die dritte Strommesseinrichtung als Shunt ausgebildet.

Als "Shunt", auch als Nebenwiderstand oder Nebenschlusswiderstand bezeichnet, wird ursprünglich ein elektrisch leitendes Bauteil bezeichnet, das zu einem Teil eines Stromkreises parallelgeschaltet ist, um einen Teil des dort fließenden elektrischen Stroms abzuleiten. Gemäß einer begrifflichen Weiterentwicklung wird unter dem Begriff "Shunt" ein Strommesswiderstand, d.h. einen niederohmigen elektrischen Messwiderstand, verstanden, der unmittelbar in der stromführenden elektrischen Leitung angeordnet ist, so dass durch einem zu dem Shunt parallelgeschalteten Spannungsmessgerät nur ein kleiner Teil des elektrischen Stroms fließt.

Der Einsatz eines Shunts stellt somit eine weitere Alternative zur Realisierung der Strommesseinrichtung dar. Vorzugsweise ist ferner ein Analog-Digital-Wandler, sog. ADC ("analog-to-digital converter") vorgesehen, um die analogen Messsignale in digitale Signale umzuwandeln.

Gemäß einer weiteren vorteilhaften Weiterbildung der Summenstromwandler-Baugruppe ist der erste Messwandler zur Erfassung eines Wechsel-Fehlerstroms oder zur Erfassung eines Gleich-Fehlerstroms ausgebildet. Somit können für verschiedene Anwendungsfälle auf einfache Art und Weise unterschiedliche Varianten der Summenstromwandler-Baugruppe gebildet werden.

Gemäß einer weiteren vorteilhaften Weiterbildung weist die Summenstromwandler-Baugruppe einen zweiten Messwandler zur Erfassung eines Fehlerstroms auf, wobei der eine der ersten oder zweiten Messwandler zur Erfassung eines Wechsel-Fehlerstroms, und der andere der ersten oder zweiten Messwandler zur Erfassung eines Gleich-Fehlerstroms ausgebildet ist.

Durch den Einsatz zweier Messwandler ist eine allstromsensitive Fehlerstromerfassung, d.h. der Erfassung sowohl von Wechsel-Fehlerströmen als auch von Gleich-Fehlerströmen realisierbar.

Gemäß einer weiteren vorteilhaften Weiterbildung der Summenstromwandler-Baugruppe ist die Leiterplatte als starr-flex-Leiterplatte mit zumindest zwei starren Bereichen, die durch zumindest einen flexiblen Abschnitt miteinander verbunden sind, ausgebildet.

Durch die Verwendung einer sogenannten starr-flex-Leiterplatte kann der im Gehäuse des Fehlerstromerfassungsgerätes zur Verfügung stehende Bauraum besser ausgenutzt werden. Die starren Bereiche, aus herkömmlichem Leiterplattenmaterial gefertigt und mit Bauelementen bestückbar, sind über den flexiblen Abschnitt sowohl mechanisch als auch elektrisch miteinander verbunden. Der flexible Abschnitt kann beispielsweise durch ein Flachbandkabel gebildet sein. Die starr-flex-Leiterplatte kann auch mehr als zwei starre Bereiche aufweisen, wobei dann entsprechend der Anzahl der zusätzlichen starren Bereiche weitere flexible Abschnitte zum Verbinden der starren Bereiche erforderlich sind.

Gemäß einer weiteren vorteilhaften Weiterbildung der Summenstromwandler-Baugruppe weist die Leiterplatte ein als Flachbandkabel ausgebildetes Anschlusselement zur elektrischen Kontaktierung der Leiterplatte auf.

Mit Hilfe des als Flachbandkabel ausgebildeten Anschlusselements ist im Rahmen der Montage der Summenstromwandler-Baugruppe im Gehäuse des Fehlerstromerfassungsgerätes eine einfache elektrische Kontaktierung der Leiterplatte realisierbar. Das freie Ende des Flachbandkabels weist hierzu vorteilhafterweise ein Steckelement auf, welches in eine im Gehäuse des Fehlerstromerfassungsgerätes angeordnete Buchse eingesteckt wird.

Das erfindungsgemäße Gerät zur Fehlerstromerfassung zeichnet sich dadurch aus, dass es eine Summenstromwandler-Baugruppe der vorstehend beschriebenen Art aufweist. Hinsichtlich der prinzipiellen Vorteile des erfindungsgemäßen Fehlerstromerfassungsgerätes wird auf die vorstehenden Ausführungen die Vorteile der erfindungsgemäßen Summenstromwandler-Baugruppe betreffend verwiesen.

In einer vorteilhaften Weiterbildung weist das Gerät zur Fehlerstromerfassung ein erstes Gehäusemodul, in dem ein unterbrechbarer Strompfad zur Kontaktierung eines Neutralleiters angeordnet ist, sowie zumindest ein zweites Gehäusemodul, in dem ein unterbrechbarer Strompfad zur Kontaktierung eines Phasenleiters angeordnet ist, auf. Die Gehäusemodule sind dabei nebeneinander angeordnet sowie mechanisch miteinander verbunden und weisen jeweils ein Isolierstoffgehäuse mit einer Frontseite, einer dieser gegenüberliegenden Befestigungsseite sowie die Front- und die Befestigungsseite verbindenden Schmal- und Breitseiten auf. Dabei weist jedes der Isolierstoffgehäuse jeweils eine sich von der einen zur anderen Breitseite erstreckende Einschuböffnung auf, wodurch bei Kombination des ersten Gehäusemoduls mit zumindest einem zweiten Gehäusemodul ein modulübergreifender Einbauraum gebildet ist, in dem die Summenstromwandler-Baugruppe aufgenommen und gehaltert ist.

In einer weiteren vorteilhaften Weiterbildung ist das Gerät zur Fehlerstromerfassung 2-polig, 3-polig oder 4-polig ausgebildet und weist dementsprechend ein Isolierstoffgehäuse mit einem ersten Gehäusemodul zur Kontaktierung eines Neutralleiters sowie einem, zwei oder drei zweiten Gehäusemodulen zur Kontaktierung jeweils eines Phasenleiters auf. Die Summenstromwandler-Baugruppe ist dementsprechend 2-polig, 3-polig oder 4-polig ausgebildet und weist eine der Anzahl der Phasenleiter entsprechende Anzahl an Strommesseinrichtungen auf.

Das erste Gehäusemodul ist als RCD-Modul ausgebildet, in dem der unterbrechbare Strompfad zur Kontaktierung mit dem Neutralleiter angeordnet ist. Weiterhin sind in dem ersten Gehäusemodul diverse RCD-Funktionsbaugruppen, beispielsweise ein Haltemagnet, eine Elektronik oder eine Auslösespule, aufgenommen und gehaltert. Das zumindest eine zweite Gehäusemodul ist als MCB-Modul ausgebildet, in dem der unterbrechbare Strompfad zur Kontaktierung mit dem zumindest einen Phasenleiter angeordnet ist. Die Unterbrechung des im ersten Gehäusemodul bzw. im zweiten Gehäusemodul angeordneten Strompfads kann beispielsweise mit Hilfe eines im jeweiligen Strompfad angeordneten Schaltkontakts erfolgen, bei dem ein bewegliches Kontaktelement von einem ortsfest im Gehäuse angeordneten festen Kontaktelement wegbewegt wird. Der Schaltkontakt wird dabei mit Hilfe einer Schaltmechanik betätigt, die beispielsweise ein magnetisches Auslösesystem zur Erfassung eines Kurzschlusses und/oder ein thermisches Auslösesystem zur Erfassung einer thermischen Überlast aufweist.

Der modulübergreifende Einbauraum dient dazu, eine großvolumige Funktionsbaugruppe wie beispielsweise die Summenstromwandler-Baugruppe darin aufzunehmen und zu haltern. Da der Neutralleiter sowie der zumindest eine Phasenleiter bereits vor der Montage der Summenstromwandler-Baugruppe durch den Summenstromwandler hindurchgefädelt sind, ist es möglich, die Summenstromwandler-Baugruppe erst gegen Ende der Montagereihenfolge zu montieren, wenn das erste Gehäusemodul sowie das zumindest eine zweite Gehäusemodul bereits geschlossen sind. Der Montageaufwand - welcher insbesondere durch das Hindurchfädeln der vergleichsweise starren Primärleiter durch den Magnetkern des Summenstromwandlers bedingt ist, kann dadurch deutlich reduziert werden. Da die Primärleiter außerhalb des Isolierstoffgehäuses, und damit vor der Montage des Summenstromwandlers im Isolierstoffgehäuse durch den Magnetkern hindurchgeführt werden, ist die Montage des Niederspannungs-Schutzschaltgerätes zumindest teilautomatisiert ausführbar.

Weitere Merkmale und Merkmalskombinationen der Erfindung ergeben sich aus den Figuren und deren Beschreibungen sowie aus den Ansprüchen. Insbesondere müssen weitere Ausführungsformen der Erfindung nicht unbedingt alle Merkmale eines der Ansprüche enthalten. Weitere Ausführungsformen der Erfindungen können Merkmale oder Merkmalskombinationen aufweisen, die nicht in den Ansprüchen genannt sind.

### Dabei zeigen

### Figuren

- 1 und 2: schematische Darstellungen eines ersten Ausführungsbeispiels des erfindungsgemäßen Gerätes zur Fehlerstromerfassung in perspektivischer Ansicht;
- Figur 3: eine schematische Schnittdarstellung des in Figur 1 dargestellten Gerätes zur Fehlerstromerfassung mit einer darin aufgenommener erfindungsgemäßen Summenstromwandler-Baugruppe in perspektivischer Ansicht;
- Figuren 4 und 5: schematische Darstellungen eines ersten Ausführungsbeispiels der erfindungsgemäßen Summenstromwandler-Baugruppe, jeweils in perspektivischen Ansichten;
- Figur 6: eine schematische Darstellung eines zweiten Ausführungsbeispiels der erfindungsgemäßen Summenstromwandler-Baugruppe in perspektivischer Ansicht;
- Figur 7: eine schematische Darstellung eines zweiten Ausführungsbeispiels des erfindungsgemäßen Gerätes zur Fehlerstromerfassung in perspektivischer Ansicht;
- Figur 8: eine schematische Darstellung eines dritten Ausführungsbeispiels der erfindungsgemäßen Summenstromwandler-Baugruppe in perspektivischer Ansicht;
- Figur 9: eine schematische Darstellung eines vierten Ausführungsbeispiels der erfindungsgemäßen Summenstromwandler-Baugruppe in perspektivischer Ansicht.

In den verschiedenen Figuren der Zeichnung sind gleiche oder funktionsgleiche Elemente mit dem gleichen Bezugszeichen versehen. Die Beschreibung gilt für alle Zeichnungsfiguren, in denen das entsprechende Teil ebenfalls zu erkennen ist.

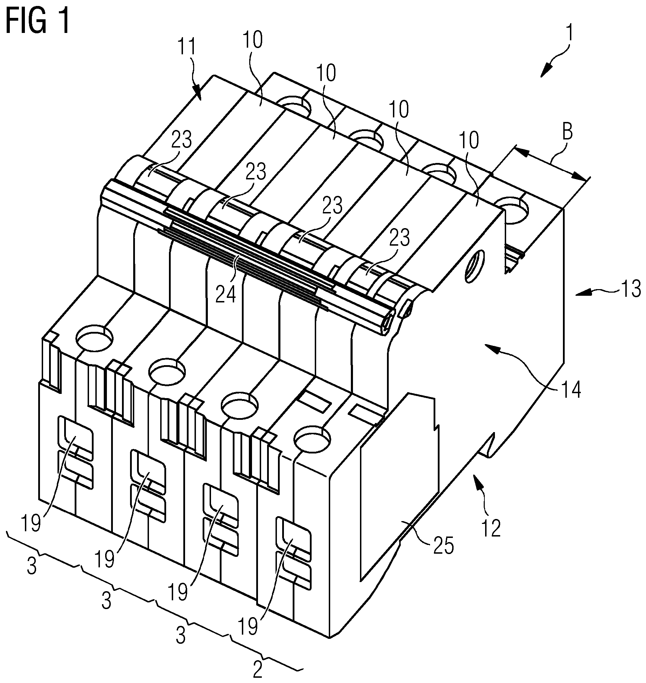

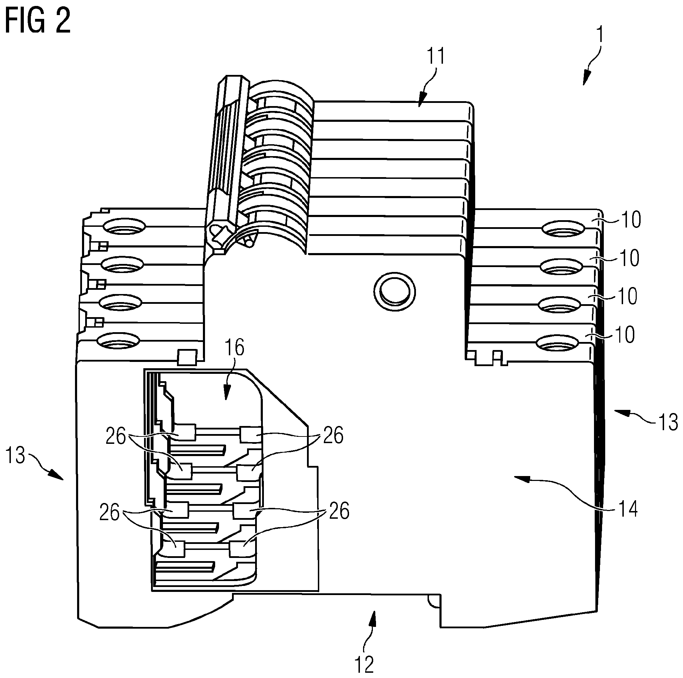

In den Figuren 1 und 2 ist der prinzipielle Aufbau eines ersten Ausführungsbeispiels des erfindungsgemäßen Gerätes zur Fehlerstromerfassung, hier eines modularen Fehlerstromschutzschalters 1 in zwei verschiedenen perspektivischen Ansichten schematisch dargestellt. Der als FI/LS bzw. RCBO ausgebildete vierpolige Fehlerstromschutzschalter 1 ist aus vier einzelnen Modulen, einem RCD-Modul 2 (in Figur 1 rechts dargestellt) sowie drei MCB-Modulen 3 gebildet, welche jeweils ein eigenständiges, strukturmechanisch stabiles Isolierstoffgehäuse 10 aufweisen.

Die Isolierstoffgehäuse 10 sind jeweils in Schmalbauweise ausgeführt und weisen eine Breite B von nur einer Teilungseinheit (1TE, entspr. ca. 18mm) auf, wobei die Außenmaße definierende Hüllflächen durch eine Frontseite 11, eine der Frontseite 11 gegenüberliegend angeordnete Befestigungsseite 12, sowie die Front- und die Befestigungsseite 11, 12 verbindende Schmalseiten 13 und Breitseiten 14 gebildet sind. Im Bereich der Schmalseiten 13 sind jeweils Schraubklemmen 19 zur Kontaktierung mit netz- bzw. lastseitigen Anschlussleitern (nicht dargestellt) im jeweiligen Isolierstoffgehäuse 10 des jeweiligen Moduls aufgenommen und gehaltert. Zur manuellen Betätigung weist jedes der Module 2, 3 ein im Bereich seiner Frontseite 11 angeordnetes Betätigungselement 23 auf. Eine gemeinsame Betätigung der einzelnen Betätigungselemente 23 ist mittels eines die einzelnen Betätigungselemente 23 koppelndes Verbindungselements 24 realisiert.

In der Regel weisen Isolierstoffgehäuse 10 in Schmalbauweise zwei Halbschalen auf, welche am Ende der Montage des Niederspannungs-Schutzschaltgerätes 1 mittels geeigneter Verbindungsmittel, beispielsweise Niet- oder Rastverbindungen, unter Ausbildung einer umlaufenden Fügelinie zusammengefügt werden. Zu jeder Halbschale gehört dabei eine der Breitseiten 14 sowie Teile (ganz oder vollständig) der Front-, Befestigungs- und Schmalseiten 11, 12, 13.

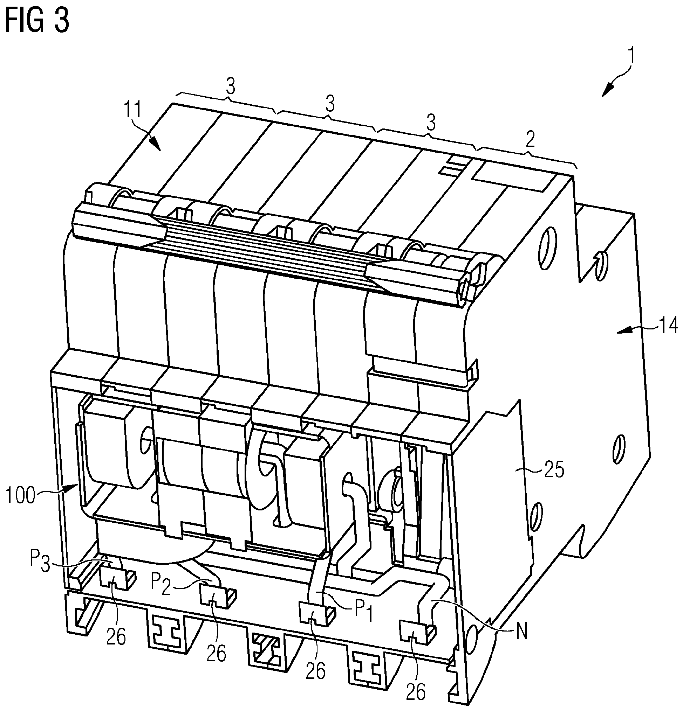

in den Breitseiten 14 jedes der Isolierstoffgehäuse 10 ist eine Einschuböffnung ausgebildet, welche sich orthogonal zu den Breitseiten 14 von der einen zur anderen Breitseite 14 erstreckt, wodurch ein Einbauraum gebildet ist. In den Einbauraum ragen seitlich elektrische Anschlusselemente 26 des jeweiligen Moduls 2 bzw. 3 hinein. Durch die Montage der einzelnen Module 2 und 3 zu einem mehrpoligen Gerät - hier zu dem in den Figuren 1 und 2 dargestellten, vierpoligen FI/LS bzw. RCBO - wird aus den Einbauräumen der Seite-an-Seite nebeneinander montierten Module 2 und 3 ein modulübergreifender Einbauraum 16 gebildet, in dem eine großvolumige Baugruppe, beispielsweise eine Summenstromwandler-Baugruppe 100 (siehe Figur 3), angeordnet, d.h. aufgenommen und gehaltert werden kann. Der modulübergreifende Einbauraum 16 ist dabei außermittig, d.h. zu einer der Schmalseiten 13 hin verschoben, im Isolierstoffgehäuse 10 platziert und über jede der beiden Breitseiten 14 zugänglich. Zum Schutz vor Umwelteinflüssen wie Staub oder Feuchtigkeit sind die Einschuböffnungen mittels geeigneter Verschlusselemente, beispielsweise eines Deckels 25, verschließbar.

Figur 3 zeigt schematisch den aus den Figuren 1 und 2 prinzipiell vorbekannten vierpoligen Fehlerstromschutzschalter 1 mit der darin aufgenommenen, erfindungsgemäßen Summenstromwandler-Baugruppe 100 in einer perspektivischen Schnittdarstellung. Hierbei wurde die vordere Schmalseite 13 des Isolierstoffgehäuses 10 mit den dahinter montierten Schraubklemmen weggelassen, um einen Einblick in das Innere des Isolierstoffgehäuses 10 - insbesondere den modulübergreifenden Einbauraum 16 mit der darin angeordneten Summenstromwandler-Baugruppe 100 - zu erhalten. Dabei ist gut zu erkennen, dass jedes der Gehäusemodule 2, 3 einen Einbauraum aufweist, woraus bei einer Aneinanderreihung der einzelnen Gehäusemodule 2, 3 der modulübergreifende Einbauraum 16 entsteht. Über in den Breitseiten 14 des Isolierstoffgehäuses 10 beidseitig ausgebildete Öffnungen kann die vormontierte Summenstromwandler-Baugruppe 100 seitlich in das Isolierstoffgehäuse 10 eingeschoben werden.

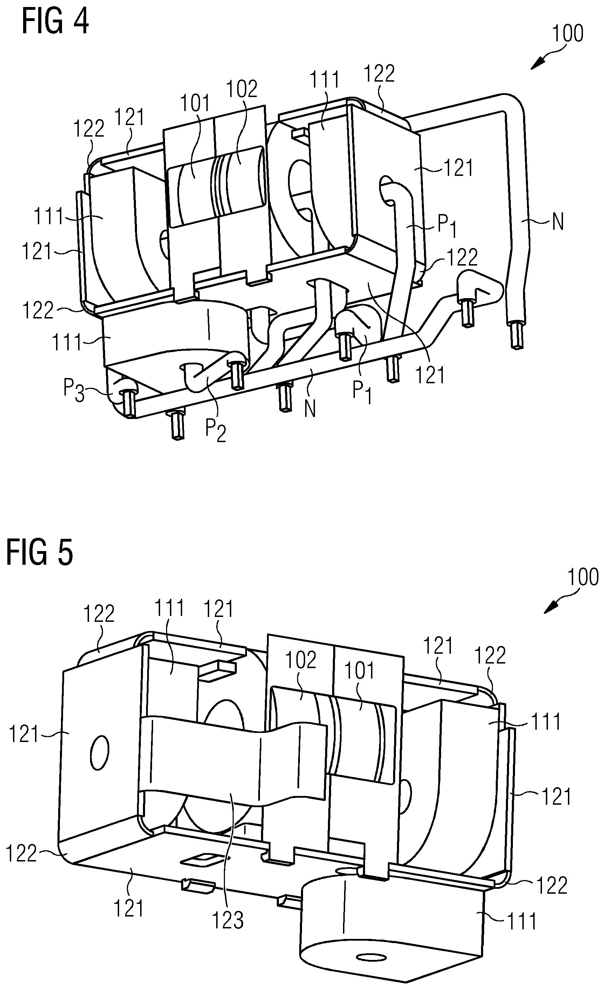

Im dargestellten Fall ist die Summenstromwandler-Baugruppe 100 bereits im Isolierstoffgehäuse 10 montiert, die in den Breitseiten 14 ausgebildeten Öffnungen sind mit Deckeln 25 verschlossen. Da es sich bei dem hier dargestellten ersten Ausführungsbeispiel um einen vierpoligen Fehlerstromschutzschalter 1 handelt, ist auch die Summenstromwandler-Baugruppe 100 vierpolig ausgeführt und weist vier Primärleiter - einen Neutralleiter N sowie drei Phasenleiter P₁, P₂ und P₃ - auf, welche allesamt mit dem ihnen jeweils zugeordneten Anschlusselement 26 des Fehlerstromschutzschalters 1 elektrisch leitend verbunden sind. Im Folgenden wird die erfindungsgemäße Summenstromwandler-Baugruppe 100 anhand der Darstellungen der Figuren 4 und 5 näher beschrieben.

In den Figuren 4 und 5 ist ein erstes Ausführungsbeispiel der erfindungsgemäßen Summenstromwandler-Baugruppe 100 - jeweils in perspektivischer Ansicht - schematisch dargestellt. Figur 4 zeigt dabei eine Vorderansicht der Summenstromwandler-Baugruppe 100 nach der Montage der Primärleiter P₁, P₂, P₃ und N; Figur 5 eine Rückansicht der Summenstromwandler-Baugruppe 100 vor der Montage der Primärleiter P₁, P₂, P₃ und N.

Die Summenstromwandler-Baugruppe 100 weist einen ersten Messwandler 101 zur Erfassung eines Wechsel-Fehlerstroms sowie einen zweiten Messwandler 102 zur Erfassung eines Gleich-Fehlerstroms auf. Der erste und der zweite Messwandler 101 und 102 sind zentral in der Summenstromwandler-Baugruppe 100 angeordnet und weisen jeweils einen ringförmigen Magnetkern (nicht dargestellt) auf, durch den alle Primärleiter, d.h. alle drei Phasenleiter P₁, P₂ und P₃ sowie der Neutralleiter N, hindurchgeführt sind. Erfindungsgemäß ist es jedoch nicht zwingend erforderlich, den Fehlerstromschutzschalter 1 allstromsensitiv, d.h. zur Erfassung sowohl von Wechsel-Fehlerströmen als auch zur Erfassung von Gleich-Fehlerströmen auszubilden. Es wäre ebenso möglich und im Sinne der Erfindung, einen der beiden Messwandler, entweder den ersten Messwandler 101 oder den zweiten Messwandler 102, wegzulassen, um einen Fehlerstromschutzschalter zur ausschließlichen Erfassung von Gleich-Fehlerströmen oder zur ausschließlichen Erfassung von Wechselfehlerströmen zu erhalten.

Weiterhin weist die Summenstromwandler-Baugruppe 100 drei Strommesseinrichtungen auf, welche jeweils einem der drei Phasenleiter P₁, P₂, P₃ zugeordnet und im dargestellten ersten Ausführungsbeispiel als Stromwandler 111 ausgebildet sind. Die als Stromwandler 111 ausgebildeten Strommesseinrichtungen weisen einen ringförmigen Magnetkern auf und dienen dazu, den im jeweiligen Phasenleiter fließenden Laststrom zu erfassen. Hierzu ist jeder der Phasenleiter durch die Öffnung des ihm zugeordneten ringförmigen Stromwandlers 111 hindurchgeführt.

Ferner weist die Summenstromwandler-Baugruppe 100 eine Leiterplatte auf, welche in diesem ersten Ausführungsbeispiel als starr-flex Leiterplatte, bestehend mehreren starren Leiterplatten-Bereichen 121, die über flexible Leiterplatten-Abschnitte 122 miteinander verbunden sind, ausgebildet ist. Die flexiblen Abschnitte 122 können als rein mechanische, aber auch als mechanische und elektrische Verbindung zweier starrer Bereiche 121 ausgebildet sein. An den starren Bereichen 121 sind die einzelnen Komponenten der Summenstromwandler-Baugruppe 100, d.h. der erste Messwandler 101 und der zweite Messwandler 102 sowie die drei Stromwandler 111, befestigt, d.h. aufgenommen und gehaltert. Die starr-flex Leiterplatte dient also nicht nur der Anordnung und Befestigung der einzelnen elektrischen Bauelemente, sondern bildet auch das strukturmechanische Tragwerk, welches der Summenstromwandler-Baugruppe 100 ihre mechanische Stabilität verleiht und damit die Montage - sowohl der Summenstromwandler-Baugruppe 100 selbst als auch deren Montage im modulübergreifenden Einbauraum 16 des Fehlerstromschutzschalters 1 - deutlich erleichtert.

Weiterhin sind auf der Leiterplatte elektrische Bauelemente, beispielsweise eine elektrische Schaltung (nicht dargestellt) zur Messung der Spannung in den drei Phasenleitern P₁, P₂, P₃ angeordnet. Darüber hinaus können auch weitere Komponenten oder Funktionsbaugruppen, beispielsweise zur drahtlosen oder drahtgebundenen Kommunikation, auf der Leiterplatte angeordnet sein. Zur elektrischen Kontaktierung der Summenstromwandler-Baugruppe 100 ist an einem der starren Bereiche 121 der Leiterplatte ein als Flachbandkabel 123 ausgebildetes Anschlusselement vorgesehen, welches im Rahmen der Montage der Summenstromwandler-Baugruppe 100 im Isolierstoffgehäuse 10 in eine am Fehlerstromschutzschalter 1 ausgebildete Steckbuchse (nicht dargestellt) eingesteckt wird.

In dem in den Figuren 1 bis 5 dargestellten ersten Ausführungsbeispiel ist der Fehlerstromschutzschalter 1 vierpolig ausgebildet, d.h. bei der Montage werden vier externe Anschlussleiter (nicht dargestellt) - drei Phasenleiter sowie ein Neutralleiter - an den Fehlerstromschutzschalter 1 angeschlossen, d.h. elektrisch leitend mit diesem verbunden. Dementsprechend ist die dazugehörige Summenstromwandler-Baugruppe 100 ebenfalls vierpolig ausgeführt und weist vier Primärleiter - drei Phasenleiter P₁, P₂ und P₃ sowie den Neutralleiter N - zur elektrischen Kontaktierung mit den vier externen Anschlussleitern auf. Auf der Basis des in den Figuren 1 bis 3 dargestellten modularen Gehäusedesigns kann durch Weglassen eines oder zweier MCB-Module 2 auch ein drei- oder zweipoliger Fehlerstromschutzschalter gebildet werden. Die hierfür benötigte Summenstromwandler-Baugruppe wäre dementsprechend konstruktiv anzupassen.

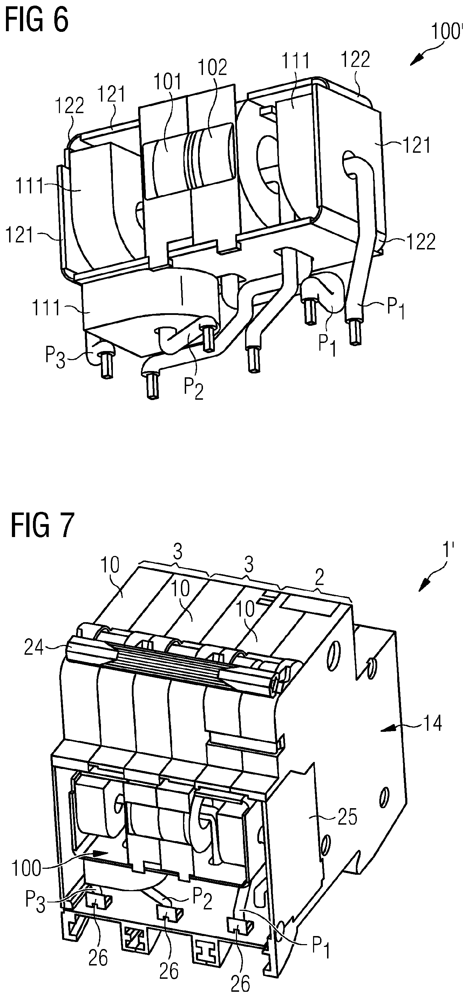

In den Figuren 6 und 7 ist ein zweites Ausführungsbeispiel der erfindungsgemäßen Summenstromwandler-Baugruppe 100' sowie des hierzu korrespondierenden, erfindungsgemäßen Fehlerstromschutzschalters 1' in perspektivischer Ansicht schematisch dargestellt. Im Unterschied zum ersten Ausführungsbeispiel ist der in Figur 7 dargestellte Fehlerstromschutzschalter 1' für einen dreiphasigen Anschluss ohne Neutralleiter - beispielsweise für einen dreiphasigen Motoranschluss - vorgesehen. Dementsprechend ist dieser Fehlerstromschutzschalter 1' aus drei einzelnen Modulen, einem RCD-Modul 2 sowie drei MCB-Modulen 3 gebildet, welche jeweils ein eigenständiges, strukturmechanisch stabiles Isolierstoffgehäuse 10 aufweisen. Dementsprechend weist die Summenstromwandler-Baugruppe 100' im zweiten Ausführungsbeispiel keinen Neutralleiter auf, ist aber ansonsten im Wesentlichen identisch zur der in den Figuren 3 bis 5 dargestellten Summenstromwandler-Baugruppe 100 des ersten Ausführungsbeispiels.

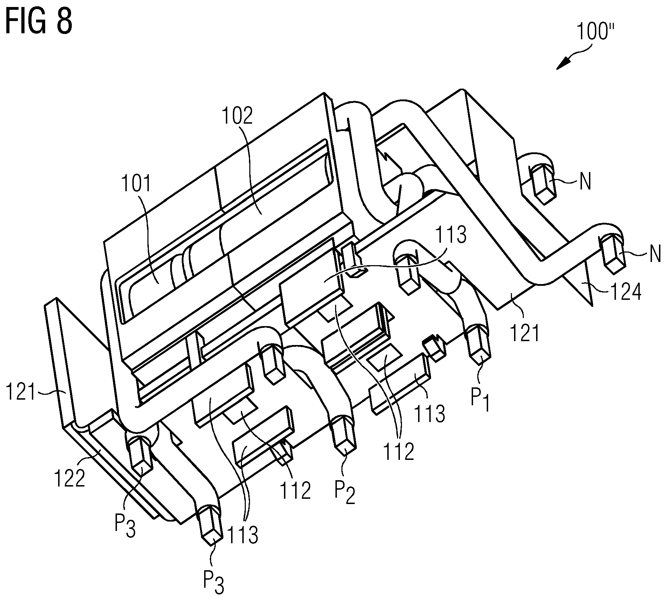

In Figur 8 ist ein drittes Ausführungsbeispiel der erfindungsgemäßen Summenstromwandler-Baugruppe 100" in perspektivischer Ansicht schematisch dargestellt. Dieses dritte Ausführungsbeispiel unterscheidet sich von den ersten beiden Ausführungsbeispielen im Wesentlichen dadurch, dass als Strommesseinrichtungen anstelle der Stromwandler 111 nunmehr Stromsensoren 112 verwendet werden, um den im jeweiligen Phasenleiter P₁, P₂, P₃ fließenden Laststrom zu erfassen. Als Stromsensoren 112 können beispielsweise Hall-Sensoren oder TMR-(englisch: "tunnel magneto resistance") Sensoren eingesetzt werden. Die Stromsensoren 112 sind auf einem starren Bereich 121 der starr-flex-Leiterplatte angeordnet, wobei der dem jeweiligen Stromsensor 112 zugeordnete Phasenleiter P₁, P₂, P₃ in unmittelbarer Nähe des betreffenden Stromsensors 112 vorbeigeführt sein muss. Um Wechselwirkungen mit den Magnetfeldern der anderen Phasenleiter zu reduzieren sind beidseitig der Stromsensoren 112 jeweils magnetische Abschirmelemente 113 angeordnet, d.h. an der Leiterplatte befestigt.

Auch im dritten Ausführungsbeispiel ist die Summenstromwandler-Baugruppe 100"allstromsensitiv ausgebildet und weist einen ersten Messwandler 101 zur Erfassung eines Wechselfehlerstroms sowie einen zweiten Messwandler 102 zur Erfassung eines Gleichfehlerstroms auf. Ferner ist ein Ende 124 eines starren Bereichs 121 der starr-flex-Leiterplatte so ausgebildet, dass es im Rahmen der Montage der Summenstromwandler-Baugruppe 100" in eine im Isolierstoffgehäuse 10 des Fehlerstromschutzschalters 1" angeordnete Steckbuchse (nicht dargestellt) für ein Flachbandkabel eingesteckt werden kann, um die Summenstromwandler-Baugruppe 100" elektrisch zu kontaktieren.

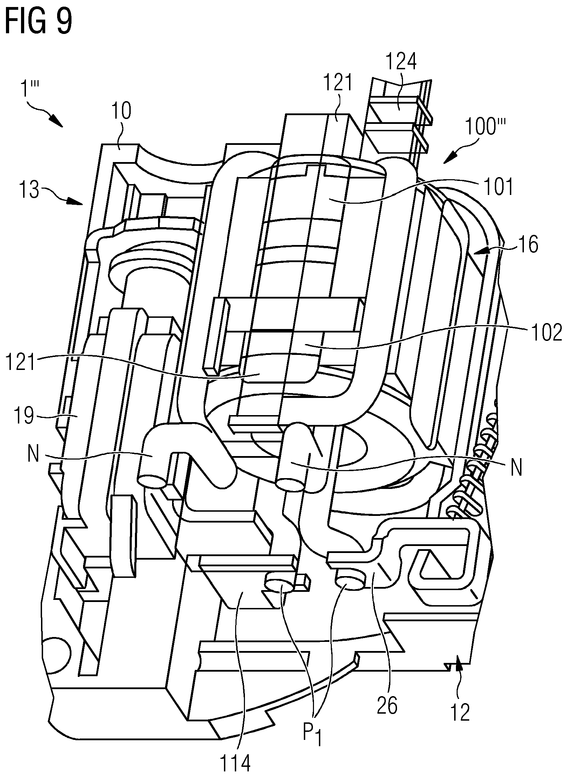

Figur 9 zeigt schematisch eines viertes Ausführungsbeispiel der erfindungsgemäßen Summenstromwandler-Baugruppe 100‴ in perspektivischer Ansicht. Diese Summenstromwandler-Baugruppe 100‴ ist zweipolige ausgeführt und dementsprechend im Isolierstoffgehäuse 10 eines zweipoligen Fehlerstromschutzschalter 1‴, bestehend aus einem MCB-Modul 2 und einem RCD-Modul 3 (siehe Figur 1), vormontiert. Die Darstellung der Figur 9 zeigt dabei einen Teil des Isolierstoffgehäuse 10 des MCB-Moduls 2. Zur Kontaktierung mit netz- bzw. lastseitigen Anschlussleitern (ein Phasenleiter und ein Neutralleiter, nicht dargestellt) sind im Bereich der Schmalseiten 13 des Isolierstoffgehäuse 10 des Fehlerstromschutzschalters 1‴ jeweils zwei Schraubklemmen 19 angeordnet, d.h. aufgenommen und gehaltert.

Dieses vierte Ausführungsbeispiel unterscheidet sich von den ersten beiden Ausführungsbeispielen im Wesentlichen dadurch, dass zur Strommessung des Laststroms in dem einen Phasenleiter P₁ nunmehr ein Shunt 114 anstelle eines Stromwandlers oder eines Stromsensors eingesetzt wird. Unter dem Begriff "Shunt" wird dabei ein Strommesswiderstand, d.h. ein niederohmiger elektrischer Messwiderstand, bezeichnet, der unmittelbar in die stromführende Leitung eingefügt ist.

Auch im vierten Ausführungsbeispiel ist die Summenstromwandler-Baugruppe 100‴allstromsensitiv ausgebildet und weist einen ersten Messwandler 101 zur Erfassung eines Wechselfehlerstroms sowie einen zweiten Messwandler 102 zur Erfassung eines Gleichfehlerstroms auf. Ferner ist wiederum ein Ende 124 eines starren Bereichs 121 der starr-flex-Leiterplatte so ausgebildet, d.h. geformt und angeordnet, dass es im Rahmen der Montage der Summenstromwandler-Baugruppe 100‴ in eine im Isolierstoffgehäuse 10 des Fehlerstromschutzschalters 1‴ angeordnete Steckbuchse (nicht dargestellt) für ein Flachbandkabel eingesteckt werden kann, um die Summenstromwandler-Baugruppe 100‴ elektrisch zu kontaktieren.

Anstatt die Funktionen wie "Fehlerstromanzeige und -überwachung" (sogenanntes "residual current monitoring", kurz: RCM) sowie Energiemessung mittels eines eigenständigen Gerätes zu realisieren, können diese Funktionen mit Hilfe der erfindungsgemäßen Summenstromwandler-Baugruppen 100, 100', 100", 100‴ in einen bestehendes Fehlerstromerfassungsgerät, beispielsweise die vorstehend beschriebenen Fehlerstromschutzschalter 1, 1', 1", 1‴, integriert werden. Hierdurch wird einerseits Platz im Elektroinstallationsverteiler eingespart. Andererseits ist die Integration dieser Funktionen in ein bestsehendes Gerät deutlich günstiger als bei Realisierung in einem eigenständigen Gerät. Darüber hinaus wird eine Nachrüstung dieser Funktionen in einer bestehenden Anlage deutlich vereinfacht.

### Bezugszeichenliste

- 1, 1', 1", 1‴: Fehlerstromschutzschalter
- 2: RCD-Modul
- 3: MCB-Modul

- 10: Isolierstoffgehäuse
- 11: Frontseite
- 12: Befestigungsseite
- 13: Schmalseite
- 14: Breitseite
- 16: Einbauraum
- 19: Schraubklemme
- 23: Betätigungselement
- 24: Verbindungselement
- 25: Deckel
- 26: Anschlusselement

- 100, 100', 100", 100‴: Summenstromwandler-Baugruppe
- 101: erster Messwandler
- 102: zweiter Messwandler

- 111: Stromwandler
- 112: Stromsensor
- 113: Abschirmelement
- 114: Shunt

- 121: starrer Bereich
- 122: flexibler Abschnitt
- 123: Flachbandkabel
- 124: Ende

- B: Breite
- N: Neutralleiter
- P₁, P₂, P₃: Phasenleiter

## Patentansprüche

1. Summenstromwandler-Baugruppe (100, 100', 100", 100‴) für ein Fehlerstromerfassungsgerät (1, 1', 1", 1‴), mit
- einem ersten Messwandler (101) zur Erfassung eines Fehlerstroms,
- einer ersten Strommesseinrichtung (111, 112, 114) zur Erfassung eines in einem ersten Phasenleiter (P₁) des Fehlerstromerfassungsgerätes (1, 1', 1", 1‴) fließenden Laststroms, sowie
- eine Leiterplatte (121), auf der eine elektrische Schaltung zur Messung der Spannung im ersten Phasenleiter (P₁) angeordnet ist,
wobei der erste Messwandler (101) sowie die ersten Strommesseinrichtung (111, 112, 114) an der Leiterplatte (121) befestigt sowie mit dieser elektrisch leitend verbunden sind.

2. Summenstromwandler-Baugruppe (100, 100', 100", 100‴) nach Anspruch 1,
- mit einer zweiten Strommesseinrichtung (111, 112, 114) zur Erfassung eines in einem zweiten Phasenleiter (P₂) des Fehlerstromerfassungsgerätes (1, 1', 1", 1‴) fließenden Laststroms und/oder
- mit einer dritten Strommesseinrichtung (111, 112, 114) zur Erfassung eines in einem dritten Phasenleiter (P₃) des Fehlerstromerfassungsgerätes (1, 1', 1", 1‴) fließenden Laststroms,
wobei die zweite Strommesseinrichtung (111, 112, 114) und/oder die dritte Strommesseinrichtung (111, 112, 114) an der Leiterplatte (121) befestigt sowie mit dieser elektrisch leitend verbunden sind.

3. Summenstromwandler-Baugruppe (100, 100', 100", 100‴) nach einem der Ansprüche 1 bis 2,
wobei die erste Strommesseinrichtung und/oder die zweite Strommesseinrichtung und/oder die dritte Strommesseinrichtung als Stromwandler (111) ausgebildet ist/sind.

4. Summenstromwandler-Baugruppe (100, 100', 100", 100‴) nach einem der Ansprüche 1 bis 2,
wobei die erste Strommesseinrichtung und/oder die zweite Strommesseinrichtung und/oder die dritte Strommesseinrichtung als Stromsensor (112), insbesondere als TMR-Sensor oder als Hall-Sensor, ausgebildet ist/sind.

5. Summenstromwandler-Baugruppe (100, 100', 100", 100‴) nach einem der Ansprüche 1 bis 2,
wobei die erste Strommesseinrichtung und/oder die zweite Strommesseinrichtung und/oder die dritte Strommesseinrichtung als Shunt (114) ausgebildet ist/sind.

6. Summenstromwandler-Baugruppe (100, 100', 100", 100‴) nach einem der vorherigen Ansprüche,
wobei der erste Messwandler (101) zur Erfassung eines Wechsel-Fehlerstroms oder zur Erfassung eines Gleich-Fehlerstroms ausgebildet ist.

7. Summenstromwandler-Baugruppe (100, 100', 100", 100‴) nach einem der vorherigen Ansprüche,
mit einem zweiten Messwandler (102) zur Erfassung eines Fehlerstroms, wobei der eine der ersten oder zweiten Messwandler (101, 102) zur Erfassung eines Wechsel-Fehlerstroms, und der andere der ersten oder zweiten Messwandler (101, 102) zur Erfassung eines Gleich-Fehlerstroms ausgebildet ist.

8. Summenstromwandler-Baugruppe (100, 100', 100", 100‴) nach einem der vorherigen Ansprüche,
wobei die Leiterplatte als starr-flex-Leiterplatte mit zumindest zwei starren Bereichen (121), die durch zumindest einen flexiblen Abschnitt (122) miteinander verbunden sind, ausgebildet ist.

9. Summenstromwandler-Baugruppe (100, 100', 100", 100‴) nach einem der vorherigen Ansprüche,
wobei die Leiterplatte ein als Flachbandkabel (123) ausgebildetes Anschlusselement zur elektrischen Kontaktierung der Leiterplatte (121) aufweist.

10. Gerät zur Fehlerstromerfassung (1, 1', 1", 1‴) mit einer Summenstromwandler-Baugruppe (100, 100', 100", 100‴), welche nach einem der **Ansprüche 1 bis** 9 ausgebildet ist.

11. Gerät zur Fehlerstromerfassung (1, 1', 1", 1‴) nach Anspruch 10,
- mit einem ersten Gehäusemodul (2), in dem ein unterbrechbarer Strompfad zur Kontaktierung eines Neutralleiters (N) angeordnet ist,
- mit zumindest einem zweiten Gehäusemodul (3), in dem ein unterbrechbarer Strompfad zur Kontaktierung eines der Phasenleiter (P₁, P₂, P₃) angeordnet ist,
- wobei die Gehäusemodule (2, 3) nebeneinander angeordnet sowie mechanisch miteinander verbunden sind und jeweils ein Isolierstoffgehäuse (10) mit einer Frontseite (11), einer dieser gegenüberliegenden Befestigungsseite (12) sowie die Front- und die Befestigungsseite (11, 12) verbindenden Schmal- und Breitseiten (13, 14) aufweisen,
- wobei die Isolierstoffgehäuse (10) jeweils eine sich von der einen zur anderen Breitseite (14) erstreckende Einschuböffnung aufweisen, wodurch bei Kombination des ersten Gehäusemoduls (2) mit zumindest einem zweiten Gehäusemodul (3) ein modulübergreifender Einbauraum (16) gebildet ist, in dem die Summenstromwandler-Baugruppe (100, 100', 100", 100‴) aufgenommen und gehaltert ist.

12. Gerät zur Fehlerstromerfassung (1, 1', 1", 1‴) nach einem der Ansprüche 10 oder 11,
- wobei das Gerät zur Fehlerstromerfassung (1, 1', 1", 1‴) 2-polig, 3-polig oder 4-polig ausgebildet ist und entsprechend ein Isolierstoffgehäuse (10) mit einem ersten Gehäusemodul (2) zur Kontaktierung eines Neutralleiters (N) sowie einem, zwei oder drei zweiten Gehäusemodulen (3) zur Kontaktierung jeweils eines der Phasenleiter (P₁, P₂, P₃) aufweist, und
- wobei die Summenstromwandler- Baugruppe (100, 100', 100", 100‴) dementsprechend 2-polig, 3-polig oder 4-polig ausgebildet ist und eine der Anzahl der Phasenleiter (P₁, P₂, P₃) entsprechende Anzahl an Strommesseinrichtungen (111, 112, 114) aufweist.
